# EUROPÄISCHE PATENTSCHRIFT

(11) **EP 2 317 577 B1**
(45) Veröffentlichungstag und Bekanntmachung des Hinweises auf die Patenterteilung: **12.12.2018**
(21) Anmeldenummer: 10186552.5
(22) Anmeldetag: 05.10.2010
(51) Int. Cl.: H01L 35/08, H01L 35/34

(54) **Verfahren zum Herstellen eines Seebeckschenkelmoduls**
Method for producing a Seebeck module
Procédé de fabrication d'un module de branche Seebeck

(30) Priorität: 28.10.2009 DE 102009046099
(43) Veröffentlichungstag der Anmeldung: 04.05.2011
(73) Patentinhaber: Robert Bosch GmbH, 70442 Stuttgart (DE)
(72) Erfinder: Offterdinger, Joerg, 70437, Stuttgart (DE); Voigtlaender, Klaus, 73117, Wangen (DE); Danner, Reinhold, 72108, Rottenburg (DE); Zywietz, Martin, 71642, Ludwigsburg (DE); Schweiker, Markus-Alexander, 77830, Buehlertal (DE); Scheuerer, Roland, 70565, Stuttgart (DE); Goebel, Ulrich, 72760, Reutlingen (DE); Schmidt, Lothar, 72800, Eningen (DE)

(56) Entgegenhaltungen:
- JP-A- H0 864 875
- US-A1- 2003 084 935
- US-A1- 2009 014 046
- US-B1- 6 222 243

## Beschreibung

### Stand der Technik

Die Erfindung geht aus von einem Verfahren zum Herstellen eines Seebeckschenkelmoduls nach der Gattung des unabhängigen Patentanspruchs 1.

Derzeit werden in der Automobilindustrie Untersuchungen und Entwicklungen für einen thermoelektrischen Generator durchgeführt, um unter Ausnutzung des Seebeckeffekts aus einem heißen Abgasstrom Strom für das Fahrzeugbordnetz zu gewinnen und dadurch den Gesamtwirkungsgrad des Antriebs mit Verbrennungsmotor zu erhöhen. Zur Herstellung eines solchen thermoelektrischen Generators sind viele Thermoelementpaare elektrisch in Reihe zu verbinden, thermisch anzukoppeln und mechanisch zu befestigen. Die Einzelelemente jedes Thermoelements werden hier im Folgenden als "Seebeckschenkel" bezeichnet, wobei je Thermoelement zwei Schenkel mit unterschiedlich ausgeprägtem Seebeck-Effekt erforderlich sind. Ein Verbund mit einer vorgegebenen Anzahl von solchen Thermoelementpaaren wird als Seebeckschenkelmodul bezeichnet. Die üblichen Thermogeneratoren und/oder Peltierkühler besitzen in der Regel Hunderte von Thermoelementpaaren, die elektrisch in Reihe geschaltet sind, um eine genügend große Nutzspannung zu erzeugen. In der Regel werden diese flächig zusammengefügt, so dass sich mehrere Reihen auf einem Keramikträger befinden, die über metallische Verbinder miteinander in Kontakt stehen. Der Keramikträger hat zusätzlich die Funktion, die metallischen Verbinder und die Thermoschenkel mechanisch zu fixieren, nach oben und unten elektrisch zu isolieren sowie thermisch gut zu leiten. In der Regel werden die Seebeckschenkel flächig auf den Keramikträgern angebracht, welche schon mit den metallischen Verbindern bestückt sind. Die metallischen Verbinder können beispielsweise durch ein DBC-Verfahren (DBC: Direct Bonded Copper) oder durch Standard-Dichtschichtverfahren mit Silber und Nickelplating oder mit Kupfer ausgebildet werden.

Die US 2009/0014046 A1 offenbart ein Seebeckschenkelmodul mit einer vorgegebenen Anzahl von Seebeckschenkeln, welche durch metallische Verbinder in einer vorgegebenen Reihenfolge miteinander verbunden sind. Die metallischen Verbinder sind über Kontaktierschichten mit dem jeweiligen Seebeckschenkel verbunden, wobei die vorgegebene Anzahl von Seebeckschenkeln in eine vorgegebene Anzahl von Modulzeilen mit einer gleichen Anzahl von Seebeckschenkeln aufgeteilt ist. Zwei benachbarte Modulzeilen weisen jeweils eine andere Typreihenfolge der Seebeckschenkel auf, wobei jeweils zwei benachbarte Seebeckschenkel einer Modulzeile durch die metallischen Verbinder elektrisch und mechanisch miteinander verbunden sind. Die einzelnen metallischen Verbinder sind in Form einer Endloskette angeordnet.

In der Offenlegungsschrift JP08064875 wird ein Verfahren zum Herstellen eines Seebeckschenkenmoduls beschrieben.

In der Offenlegungsschrift WO 2007/098736 A2 wird beispielsweise ein Verfahren zum Herstellen von Peltiermodulen mit jeweils mehreren zwischen zwei Substraten angeordneten Peltierelementen beschrieben. Hierbei bestehen die Substrate zumindest an ihren den Peltierelementen zugewandten Seiten aus einem elektrisch isolierenden Material und sind an diesen Oberflächenseiten mit von metallischen Bereichen gebildeten Kontaktflächen versehen, mit denen die Peltierelemente bei der Herstellung mit Anschlussflächen verbunden werden. Hierbei erfolgt die Herstellung der Peltiermodule in der Weise, dass ein in geeigneter Weise hergestellter Peltierwafer in einzelne Peltierelemente zerteilt wird und diese Elemente dann an den Kontaktflächen der Keramiksubstrate über eine der Verbindungen derart befestigt werden, dass über die betreffende Verbindung an jeder Kontaktfläche ein Peltierelement vorgesehen ist und zwar an sämtlichen Kontaktflächen jeweils eines Keramik-Substrats jeweils in der selben elektrischen Orientierung bzw. mit dem selben Pol. Jeweils zwei so mit Peltierelementen vorbestückte Keramik-Substrate werden dann entsprechend aufeinander gesetzt, so dass die Peltierelemente über die Kontaktflächen elektrisch in Serie liegen. Durch eine auf die freien Enden oder Anschlussseiten der Peltierelemente aufgebrachte Lotschicht werden die Peltierelemente an jedem Keramiksubstrat mit ihrer bis dahin freiliegenden, nicht kontaktierten Anschlussseiten mechanisch sowie elektrisch mit jeweils einer Kontaktfläche an dem jeweils anderen KeramikSubstrat verbunden.

### Offenbarung der Erfindung

Das erfindungsgemäße Verfahren zum Herstellen eines Seebeckschenkelmoduls mit den Merkmalen des unabhängigen Patentanspruchs 1 hat demgegenüber den Vorteil, dass eine vorgegebene Anzahl von zwischen zwei Keramikträgern angeordneten Seebeckschenkeln in eine vorgebbare Anzahl von Modulzeilen aufgeteilt wird, wobei jeweils zwei benachbarte Seebeckschenkel einer Modulzeile durch einen metallischen Verbinder elektrisch und mechanisch miteinander verbunden werden, und wobei die einzelnen metallischen Verbinder in Form einer Endloskette angeordnet und jeweils über einen Verbindungssteg miteinander verbunden werden, wobei die Verbindungsstege nach Fertigstellung der elektrischen und mechanischen Verbindung zwischen den Seebeckschenkeln und den metallischen Verbindern durchtrennt werden. Hierbei bestehen die Keramikträger zumindest an ihren den Seebeckschenkeln zugewandten Seiten aus einem elektrisch isolierenden Material, wobei die Seebeckschenkel durch die metallischen Verbinder in einer vorgegebenen Reihenfolge mit einander verbunden werden, und wobei die metallischen Verbinder über Kontaktierschichten mit den jeweiligen Seebeckschenkeln verbunden werden.

Das hergestellte Seebeckschenkelmodul hat den Vorteil, dass die vorgegebene Anzahl von zwischen zwei Keramikträgern angeordneten Seebeckschenkeln in eine vorgegebene Anzahl von Modulzeilen mit einer gleichen Anzahl von Seebeckschenkeln aufgeteilt ist, wobei zwei benachbarte Modulzeilen jeweils eine andere Typreihenfolge der Seebeckschenkel aufweisen, wobei jeweils zwei benachbarte Seebeckschenkel einer Modulzeile durch die metallischen Verbinder elektrisch und mechanisch mit einander verbunden sind, wobei die einzelnen metallischen Verbinder in Form einer Endloskette angeordnet und jeweils über einen Verbindungssteg mit einander verbunden sind, und wobei die Verbindungsstege nach Fertigstellung der elektrischen und mechanischen Verbindung zwischen den Seebeckschenkeln und den metallischen Verbindern durchtrennbar sind. Hierbei bestehen die Keramikträger zumindest an ihren den Seebeckschenkeln zugewandten Seiten aus einem elektrisch isolierenden Material, wobei die Seebeckschenkel durch die metallischen Verbinder in einer vorgegebenen Reihenfolge miteinander verbunden sind, und wobei die metallischen Verbinder über Kontaktierschichten mit dem jeweiligen Seebeckschenkel verbunden sind.

Bei Ausführungsformen der Erfindung bilden die Keramikträger im Unterschied zum Stand der Technik nur noch die elektrische Isolation nach oben und unten sowie den thermischen Kontakt, sie halten weder die metallischen Verbinder noch die Seebeckschenkel mechanisch fest. Durch die metallischen Verbinder werden in vorteilhafter Weise Zeilen von elektrisch und mechanisch verbundenen Seebeckschenkeln gebildet, die einfach und schnell zu einem flächigen Verbund zusammengefasst werden können, der dann durch die beiden Keramikträger nach außen elektrisch isoliert und thermisch gekoppelt wird. Die Verbindungsstege sind beispielsweise außen an der jeweiligen Endloskette angeordnet und halten die Modulzeilen während des ersten Teils des Herstellprozesses des Seebeckschenkelmoduls in vorteilhafter Weise zusammen.

Durch die in den abhängigen Ansprüchen aufgeführten Maßnahmen und Weiterbildungen sind vorteilhafte Verbesserungen des im unabhängigen Patentanspruch 1 angegebenen Verfahrens zum Herstellen eines Seebeckschenkelmoduls möglich.

Besonders vorteilhaft ist, dass eine erste Endloskette für die elektrische und mechanische Verbindung von zwei benachbarten Seebeckschenkeln an deren Oberseite verwendet wird. Zusätzlich wird eine zweite Endloskette für die elektrische und mechanische Verbindung von zwei benachbarten Seebeckschenkeln an deren Unterseite verwendet. Bei den beiden Endlosketten sind die außen angeordneten Verbindungsstege in vorteilhafter Weise auf entgegengesetzten Seiten angeordnet, so dass sie nach dem Verbindungsprozess leicht entfernt werden können.

In Ausgestaltung des erfindungsgemäßen Verfahrens können die Kontaktierschichten für die elektrischen und mechanischen Verbindungen zwischen den metallischen Verbindern und den Seebeckschenkeln beispielsweise durch Sintern und/oder Löten gefertigt werden.

In weiterer Ausgestaltung des erfindungsgemäßen Verfahrens wird an jedem Ende einer Modulzeile des Seebeckschenkelmoduls ein überstehender Endsteg angeformt, um einen flächigen Verbund aus mehreren Modulzeilen aufzubauen, die jeweils eine vorgegebene gleiche Anzahl von Seebeckschenkeln aufweisen. Hierbei werden zwei benachbarte Modulzeilen an den jeweiligen überstehenden Endstegen über einen Koppelsteg elektrisch und mechanisch miteinander verbunden. Der Koppelsteg kann beispielsweise durch Schweißverbindungen mit den zugehörigen Endstegen verbunden werden. Bei einer geraden Anzahl von Seebeckschenkeln sind die Koppelstege der Modulzeilen dabei alle entweder "oben" oder "unten" an den Modulzeilen angeordnet. Bei einer ungeraden Anzahl von Seebeckschenkeln sind die Verbinder an der einen Seite "oben" und an der anderen Seite "unten" an den Modulzeilen angeordnet.

Zum Fixieren der Seebeckschenkel und der Endlosketten während des Bestückungsvorgangs und/oder Verbindungsvorgangs können beispielsweise Hilfswerkzeuge seitlich in das Gebilde eingeschoben und von der Gegenseite geschlossen werden. Nach dem Verbindungsprozess können die Hilfswerkzeuge entfernt und wieder verwendet werden. Die Hilfswerkzeuge können auch Teil einer automatisierten Einrichtung sein, welche die beiden Endlosketten abrollt und einebnet, Kontaktiermaterial zum Herstellen der Kontaktierschichten aufträgt, die Seebeckschenkel bestückt, den Verbindungsvorgang durchführt, die Verbindungsstege entfernt, die Endloslänge in geeignete Modulzeilen stückelt und das Zwischenprodukt bzw. die Modulzeilen stapelt.

Hierbei können die Endlosketten als Stanzgitter ausgeführt werden, die in vorteilhafter Weise einfach und kostengünstig hergestellt werden können.

Zudem kann an den metallischen Verbindern jeweils mindestens eine Fixierzunge angeordnet werden, welche die Seebeckschenkel seitlich fixieren, wodurch die Ausrichtung der einzelnen Modulzeilen vor dem Verbindungsprozess in vorteilhafter Weise erleichtert werden kann.

Des Weiteren können die Verbindungsstege seitlich eine Abkantung aufweisen, welche in vorteilhafter Weise die mechanische Stabilität der Verbindungsstege erhöhen.

Der Fügevorgang zwischen den Keramikträgern und dem flächigen Verbund aus Modulzeilen muss für einen guten thermischen Kontakt sorgen, so dass bei Bedarf ein Wärmeleitmedium verwendet werden kann. Der mechanische Zusammenhalt des Seebeckschenkelmoduls kann beispielsweise über eine hermetisch dichte Verpackung gesichert werden.

Vorteilhafte Ausführungsformen der Erfindung sind in den Zeichnungen dargestellt und werden nachfolgend beschrieben. In den Zeichnungen bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Schnittdarstellung eines Ausschnitts eines Seebeckschenkelmoduls, das gemäß einem erfindungsgemäßen Verfahren hergestellt wurde.
Figur 2 zeigt eine schematische Seitenansicht einer ersten Modulzeile mit einer vorgegebenen Anzahl von Seebeckschenkeln für das Seebeckschenkelmodul aus Fig. 1.
Figur 3 zeigt eine schematische Seitenansicht einer zweiten Modulzeile mit einer vorgegebenen Anzahl von Seebeckschenkeln für das Seebeckschenkelmodul aus Fig. 1.
Figur 4 zeigt eine schematische Detaildarstellung einer Draufsicht auf zwei benachbarte Modulzeilen während der Herstellung.
Figur 5 zeigt eine schematische Draufsicht einer ersten Endloskette für die erste bzw. zweite Modulzeile aus Fig. 2 bzw. 3.
Figur 6 zeigt eine schematische Draufsicht einer zweiten Endloskette für die erste bzw. zweite Modulzeile aus Fig. 2 bzw. 3.
Figur 7 zeigt eine schematische Detaildarstellung einer Seitenansicht einer Modulzeile während der Herstellung.
Figur 8 zeigt eine weitere schematische Detaildarstellung einer Vorderansicht einer Modulzeile während der Herstellung.

### Ausführungsformen der Erfindung

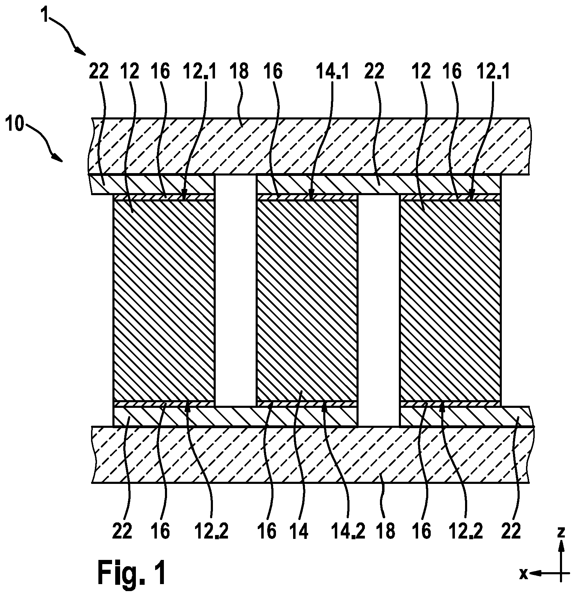

Wie aus Fig. 1 ersichtlich ist, umfasst ein Seebeckschenkelmodul 1 für einen thermoelektrischen Generator eine vorgegebene Anzahl von zwischen zwei Keramikträgern 18 angeordneten Seebeckschenkeln 12, 14, wobei die Keramikträger 16 zumindest an ihren den Seebeckschenkeln 12, 14 zugewandten Seiten aus einem elektrisch isolierenden Material bestehen. Hierbei bezeichnet das Bezugszeichen 12 Seebeckschenkel mit einer ersten Ausprägung des Seebeck-Effekts, und das Bezugszeichen 14 bezeichnet einen Seebeckschenkel mit einer zweiten Ausprägung des Seebeck-Effekts. Die Seebeckschenkel 12, 14 sind durch metallische Verbinder 22 in einer vorgegebenen Reihenfolge miteinander verbunden, wobei die metallischen Verbinder 22 über Kontaktierschichten 14 mit dem jeweiligen Seebeckschenkel 12, 14 verbunden sind.

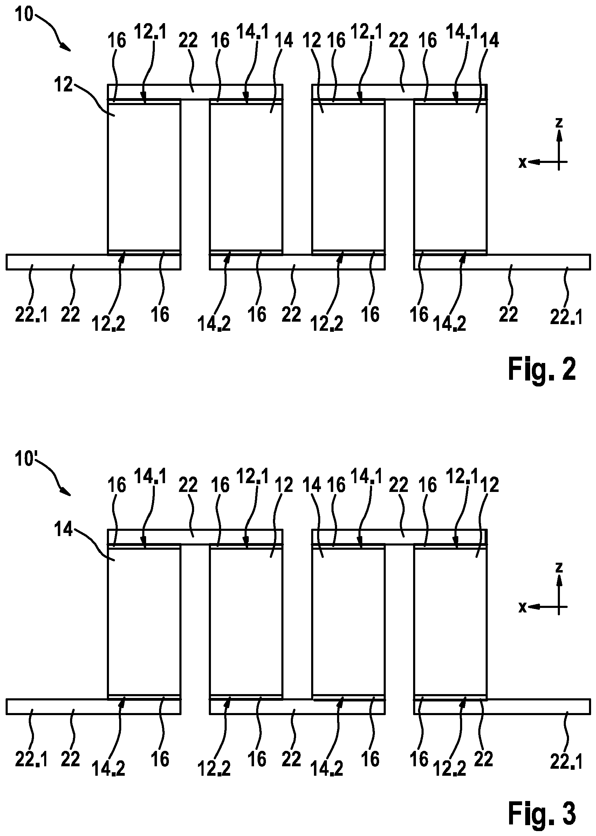

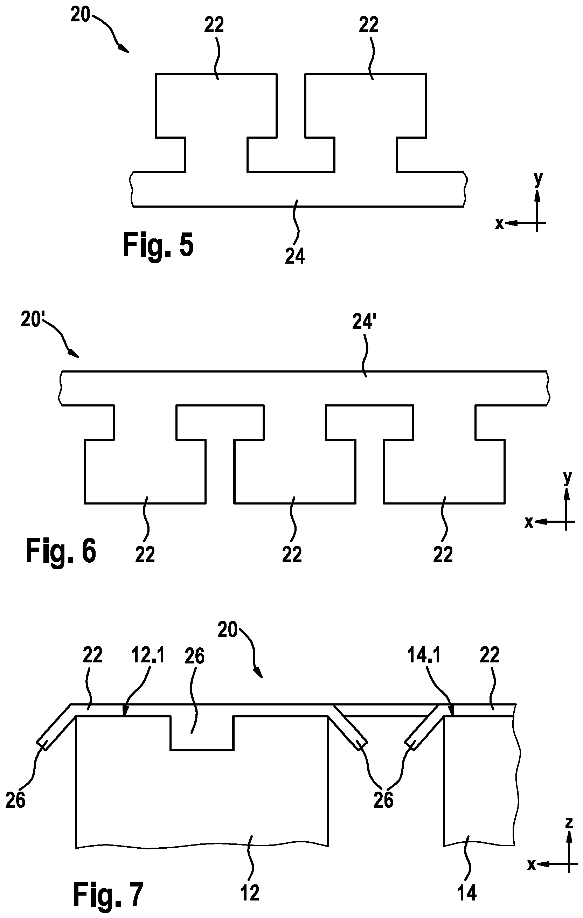

Erfindungsgemäß ist die vorgegebene Anzahl von Seebeckschenkeln 12, 14 in eine vorgegebene Anzahl von Modulzeilen 10, 10' mit einer gleichen Anzahl von Seebeckschenkeln 12, 14 aufgeteilt, die beispielhaft in Fig. 2 und 3 dargestellt sind. Hierbei weisen zwei benachbarte Modulzeilen 10, 10' jeweils eine andere Typreihenfolge der Seebeckschenkel 12, 14 auf, und jeweils zwei benachbarte Seebeckschenkel 12, 14 einer Moduleile 10, 10' sind durch die metallischen Verbinder 22 elektrisch und mechanisch mit einander verbunden, wobei die einzelnen metallischen Verbinder 22 in Form einer Endloskette angeordnet und jeweils über einen Verbindungssteg 24 mit einander verbunden sind. Die Endloskette ist beispielsweise als Stanzgitter 20, 20' ausgeführt, wie aus Fig. 5 und 6 ersichtlich ist. Die Verbindungsstege 24 werden nach Fertigstellung der elektrischen und mechanischen Verbindung zwischen den Seebeckschenkeln 12, 14 und den metallischen Verbindern 22 durchtrennt.

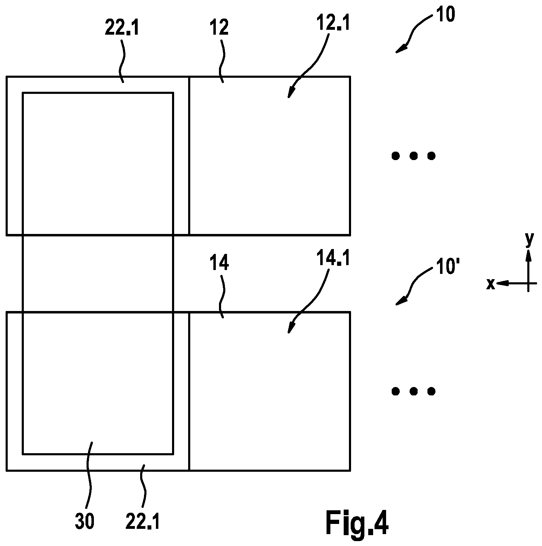

Wie aus Fig. 2 und 3 weiter ersichtlich ist, weisen die beiden Modulzeilen 10, 10' im dargestellten Ausführungsbeispiel zur Vereinfachung der Beschreibung jeweils nur vier Seebeckschenkel 12, 14 auf. Hierbei steht an jedem Ende einer Modulzeile 10, 10' des Seebeckschenkelmoduls 1 ein Endsteg 22.1 über. Dadurch ist es auf einfache Weise möglich, zwei benachbarte Modulzeilen 10, 10' an den jeweiligen überstehenden Endstegen 22.1 über einen Koppelsteg 30 elektrisch und mechanisch miteinander zu verbinden, wie aus Fig. 4 ersichtlich ist, und einen flächigen Verbund aus mehreren Modulzeilen 10, 10' zu erzeugen. Der Koppelsteg 30 kann beispielsweise durch entsprechende nicht dargestellte Schweißverbindungen mit den zugehörigen Endstegen 22.1 der beiden Modulzeilen 10, 10' verbunden werden. Bei einer geraden Anzahl von Seebeckschenkeln 12, 14 sind die Koppelstege 30 zur Verbindung der Modulzeilen 10, 10' alle entweder "oben" oder "unten angeordnet. Bei einer ungeraden Anzahl von Seebeckschenkeln 12, 14 sind die Koppelstege 30 zur Verbindung der Modulzeilen 10, 10' an der einen Seite "oben" und an der anderen Seite "unten" angeordnet.

Fig. 5 zeigt einen Ausschnitt einer ersten Endloskette 20 mit zwei metallischen Verbindern 22, welche jeweils zwei benachbarte Seebeckschenkel 12, 14 an deren Oberseite 12.1, 14.1 elektrisch und mechanisch verbinden. Wie aus Fig. 5 weiter ersichtlich ist, sind die einzelnen metallischen Verbinder 22 über einen untern angeordneten Verbindungssteg 24 miteinander mechanisch verbunden.

Fig. 6 zeigt einen Ausschnitt einer zweiten Endloskette 20' mit drei metallischen Verbindern 22, welche jeweils zwei benachbarte Seebeckschenkel 12, 14 an deren Unterseite 12.2, 14.2 elektrisch und mechanisch verbinden. Wie aus Fig. 6 weiter ersichtlich ist, sind die einzelnen metallischen Verbinder 22 über einen oben angeordneten Verbindungssteg 24' miteinander mechanisch verbunden.

Wie aus Fig. 7 ersichtlich ist, sind die Seebeckschenkel 12, 14 zur Erleichterung der Ausrichtung der einzelnen Modulzeilen 10, 10' vor dem Verbindungsprozess durch mehrere an den metallischen Verbindern 22 angeordnete Fixierzungen 26 seitlich fixiert.

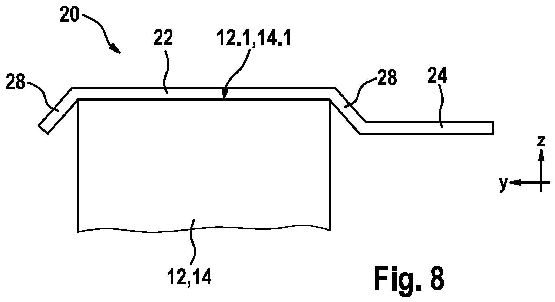

Wie aus Fig. 8 ersichtlich ist, weisen die Verbindungsstege 24 seitliche Abkantungen 28 auf, welche die mechanische Stabilität der Verbindungsstege 24 in vorteilhafter Weise erhöhen.

Gemäß dem erfindungsgemäßen Verfahren zum Herstellen eines Seebeckschenkelmoduls 1 mit einer vorgegebenen Anzahl von zwischen zwei Keramikträgern 18 angeordneten Seebeckschenkeln 12, 14 wird die vorgegebene Anzahl von Seebeckschenkeln 12, 14 in eine vorgebbare Anzahl von Modulzeilen 10, 10' aufgeteilt, wobei jeweils zwei benachbarte Seebeckschenkel 12, 14 einer Modulzeile 10, 10' durch einen metallischen Verbinder 22 elektrisch und mechanisch miteinander verbunden werden. Hierbei werden die einzelnen metallischen Verbinder 22 in Form einer Endloskette 20, 20' angeordnet und jeweils über einen Verbindungssteg 24 miteinander verbunden, wobei die Verbindungsstege 24 nach Fertigstellung der elektrischen und mechanischen Verbindung zwischen den Seebeckschenkeln 12, 14 und den metallischen Verbindern 22 durchtrennt werden.

Die Keramikträger 18 bestehen zumindest an ihren den Seebeckschenkeln 12, 14 zugewandten Seiten aus einem elektrisch isolierenden Material, wobei die Seebeckschenkel 12, 14 durch die metallischen Verbinder 22 in einer vorgegebenen Reihenfolge miteinander verbunden werden. Die Kontaktierschichten 14 zum elektrischen und mechanischen Verbinden der metallischen Verbinder 22 mit den Seebeckschenkeln 12, 14 können beispielsweise durch Sintern und/oder Löten gefertigt werden. Der Sinterprozess und/oder der Lötprozess können in einem Durchlaufofen durchgeführt werden. Alternativ kann der Lötprozess von einer Kontaktlötvorrichtung ausgeführt werden. Beim "Kontaktlötvorgang" kann der Lötprozess schnell ausgeführt werden, da die Wärmeübertragung durch einen Kontakt erfolgt und nicht durch Gas wie beim Durchlaufofen.

Zum Fixieren der Seebeckschenkel 12, 14 und der als Stanzgitter 20, 20' ausgeführten Endlosketten können während des Bestückungsvorgangs und/oder des Verbindungsgangs Hilfswerkzeuge seitlich in das Gebilde eingeschoben und von der Gegenseite geschlossen werden. Nach dem Verbindungsprozess können die Hilfswerkzeuge entfernt und wieder verwendet werden. Die Hilfswerkzeuge können als Teil einer automatisierten Einrichtung ausgeführt werden, welche die beiden Stanzgitter 20, 20' abrollt und einebnet, das Kontaktiermaterial zur Herstellung der Kontaktierschichten 16 aufträgt, die Seebeckschenkel 12, 14 bestückt, die Verbindungsvorgänge durchführt, die Verbindungsstege 24 wegstanzt, die Endloslänge zur Erzeugung der Modulzeilen 10, 10' geeignet stückelt und das Zwischenprodukt bzw. die Modulzeilen 10, 10' stapelt.

Ausführungsformen der Erfindung ermöglichen in vorteilhafter Weise eine schnellere Fertigung von Seebeckschenkelmodulen mit der vorgegebenen Anzahl von Seebeckschenkeln, da die metallischen Verbinder in vorteilhafter Weise Zeilen von elektrisch und mechanisch verbundenen Seebeckschenkeln bilden, die einfach und schnell zu einem flächigen Verbund zusammengefasst werden können, der dann durch die beiden Keramikträger nach außen elektrisch isoliert und thermisch gekoppelt wird. Die Verbindungsstege sind beispielsweise außen an der jeweiligen Endloskette angeordnet und halten die Modulzeilen während des ersten Teils des Herstellprozesses des Seebeckschenkelmoduls in vorteilhafter Weise zusammen. Die Keramikträger bilden nur noch die elektrische Isolation nach oben und unten sowie den thermischen Kontakt. Sie halten weder die metallischen Verbinder noch die Seebeckschenkel mechanisch fest.

## Patentansprüche

1. Verfahren zum Herstellen eines Seebeckschenkelmoduls mit einer vorgegebenen Anzahl von zwischen zwei Keramikträgern (18) angeordneten Seebeckschenkeln (12, 14), wobei die Keramikträger (18) zumindest an ihren den Seebeckschenkeln (12, 14) zugewandten Seiten aus einem elektrisch isolierenden Material bestehen, wobei die Seebeckschenkel (12, 14) durch metallische Verbinder (22) in einer vorgegebenen Reihenfolge miteinander verbunden werden, und wobei die metallischen Verbinder (22) über Kontaktierschichten (14) mit den jeweiligen Seebeckschenkeln (12, 14) verbunden werden, **dadurch gekennzeichnet, dass** die vorgegebene Anzahl von Seebeckschenkeln (12, 14) in eine vorgebbare Anzahl von Modulzeilen (10, 10') aufgeteilt wird, wobei jeweils zwei benachbarte Seebeckschenkel (12, 14) einer Modulzeile (10, 10') durch einen metallischen Verbinder (22) elektrisch und mechanisch miteinander verbunden werden, wobei die einzelnen metallischen Verbinder (22) in Form einer Endloskette (20, 20') angeordnet und jeweils über einen Verbindungssteg (24) miteinander verbunden werden, und wobei die Verbindungsstege (24) nach Fertigstellung der elektrischen und mechanischen Verbindung zwischen den Seebeckschenkeln (12, 14) und den metallischen Verbindern (22) durchtrennt werden.

2. Verfahren nach Anspruch 1, **dadurch gekennzeichnet, dass** eine erste Endloskette (20) für die elektrische und mechanische Verbindung von zwei benachbarten Seebeckschenkeln (12, 14) an deren Oberseite (12.1, 14.1) verwendet wird.

3. Verfahren nach Anspruch 1 oder 2, **dadurch gekennzeichnet, dass** eine zweite Endloskette (20') für die elektrische und mechanische Verbindung von zwei benachbarten Seebeckschenkeln (12, 14) an deren Unterseite (12.2, 14.2) verwendet wird.

4. Verfahren nach einem der Ansprüche 1 bis 3, **dadurch gekennzeichnet, dass** die Kontaktierschichten (16) für die elektrischen und mechanischen Verbindungen zwischen den metallischen Verbindern (22) und den Seebeckschenkeln (12, 14) durch Sintern und/oder Löten gefertigt werden.

5. Verfahren nach einem der Ansprüche 1 bis 4, **dadurch gekennzeichnet, dass** an jedem Ende einer Modulzeile (10, 10') des Seebeckschenkelmoduls (1) ein überstehender Endsteg (22.1) angeordnet wird, wobei zwei benachbarte Modulzeilen (10, 10') an den jeweiligen überstehenden Endstegen (22.1) über einen Koppelsteg (30) elektrisch und mechanisch miteinander verbunden werden.

6. Verfahren nach Anspruch 5, **dadurch gekennzeichnet, dass** der Koppelsteg (30) durch Schweißverbindungen mit den zugehörigen Endstegen (22.1) verbunden wird.

7. Verfahren nach einem der Ansprüche 1 bis 6, **dadurch gekennzeichnet, dass** die Endloskette (20, 20') als Stanzgitter ausgeführt wird.

8. Verfahren nach einem der Ansprüche 1 bis 7, **dadurch gekennzeichnet, dass** an den metallischen Verbindern (22) jeweils mindestens eine Fixierzunge (26) angeordnet wird.

9. Verfahren nach einem der Ansprüche 1 bis 8, **dadurch gekennzeichnet, dass** die Verbindungsstege (24) seitlich eine Abkantung (28) aufweisen.

## Claims

1. Method for producing a Seebeck leg module with a prespecified number of Seebeck legs (12, 14) which are arranged between two ceramic supports (18), wherein the ceramic supports (18), at least on their sides which face the Seebeck legs (12, 14), are composed of an electrically insulating material, wherein the Seebeck legs (12, 14) are connected to one another in a prespecified order by metal connectors (22), and wherein the metal connectors (22) are connected to the respective Seebeck legs (12, 14) by means of contact-making layers (14), **characterized in that** the prespecified number of Seebeck legs (12, 14) are divided into a prespecified number of module rows (10, 10'), wherein in each case two adjacent Seebeck legs (12, 14) of one module row (10, 10') are electrically and mechanically connected to one another by a metal connector (22), wherein the individual metal connectors (22) are arranged in the form of a continuous chain (20, 20') and are connected to one another by means of a connecting web (24) in each case, wherein the connecting webs (24) are severed after completion of the electrical and mechanical connection between the Seebeck legs (12, 14) and the metal connectors (22).

2. Method according to Claim 1, **characterized in that** a first continuous chain (20) is used for the electrical and mechanical connection of two adjacent Seebeck legs (12, 14) at their top side (12.1, 14.1).

3. Method according to Claim 1 or 2, **characterized in that** a second continuous chain (20') is used for the electrical and mechanical connection of two adjacent Seebeck legs (12, 14) at their bottom side (12.2, 14.2).

4. Method according to one of Claims 1 to 3, **characterized in that** the contact-making layers (16) for the electrical and mechanical connections between the metal connectors (22) and the Seebeck legs (12, 14) are produced by sintering and/or soldering.

5. Method according to one of Claims 1 to 4, **characterized in that** a protruding end web (22.1) is arranged at each end of a module row (10, 10') of the Seebeck leg module (1), wherein two adjacent module rows (10, 10') are electrically and mechanically connected to one another by means of a coupling web (30) at the respective protruding end webs (22.1).

6. Method according to Claim 5, **characterized in that** the coupling web (30) is connected to the associated end webs (22.1) by weld connections.

7. Method according to one of Claims 1 to 6, **characterized in that** the continuous chain (20, 20') is designed as a stamped grid.

8. Method according to one of Claims 1 to 7, **characterized in that** at least one fixing tongue (26) is arranged on the metal connectors (22) in each case.

9. Method according to one of Claims 1 to 8, **characterized in that** the connecting webs (24) have a bent-over portion (28) at the side.

## Revendications

1. Procédé, destiné à fabriquer un module de branches Seebeck pourvu d'un nombre prédéfini de branches Seebeck (12, 14) placées entre deux supports en céramique (18), au moins sur leurs côtés qui font face aux branches Seebeck (12, 14), les supports en céramique (18) étant constitués d'une matière isolante électrique, procédé lors duquel on relie les branches Seebeck (12, 14) les unes aux autres par des connecteurs métalliques (22) selon un ordre successif prédéfini et lors duquel les connecteurs métalliques (22) sont reliés par l'intermédiaire de couches de mise en contact (14) avec les branches Seebeck (12, 14) en question, **caractérisé en ce que** le nombre prédéfini de branches Seebeck (12, 14) est divisé en un nombre prédéfinissable de lignes de module (10, 10'), chaque fois deux branches Seebeck (12, 14) voisines d'une ligne de module (10, 10') étant reliées électriquement et mécaniquement l'une à l'autre par un connecteur métallique (22), les connecteurs métalliques (22) individuels étant placés sous la forme d'une chaîne continue (20, 20') et reliés les uns aux autres chaque fois par une barrette de liaison (24), et après l'achèvement de la liaison électrique et mécanique entre les branches Seebeck (12, 14) et les connecteurs métalliques (22), les barrettes de liaison (24) étant sectionnées.

2. Procédé selon la revendication 1, **caractérisé en ce qu'**une première chaîne continue (20) est utilisée pour la liaison électrique et mécanique de deux branches Seebeck (12, 14) voisines sur leur face supérieure (12.1, 14.1).

3. Procédé selon la revendication 1 ou 2, **caractérisé en ce qu'**une deuxième chaîne continue (20') est utilisée pour la liaison électrique et mécanique de deux branches Seebeck (12, 14) voisines sur leur face inférieure (12.2, 14.2).

4. Procédé selon l'une quelconque des revendications 1 à 3, **caractérisé en ce que** les couches de mise en contact (16) pour les liaisons électriques et mécaniques entre les connecteurs métalliques (22) et les branches Seebeck (12, 14) sont fabriquées par frittage et/ou par brasage.

5. Procédé selon l'une quelconque des revendications 1 à 4, **caractérisé en ce que** sur chaque extrémité d'une ligne de module (10, 10') du module de branches Seebeck (1) est placée une barrette finale (22.1) débordante, deux lignes de module (10, 10') voisines étant reliées électriquement et mécaniquement l'une à l'autre sur les barrettes finales (22.1) débordantes respectives par l'intermédiaire d'une barrette de couplage (30).

6. Procédé selon la revendication 5, **caractérisé en ce que** la barrette de couplage (30) est reliée par des soudures avec les barrettes finales (22.1) correspondantes.

7. Procédé selon l'une quelconque des revendications 1 à 6, **caractérisé en ce que** la chaîne continue (20, 20') est réalisée sous la forme d'une grille découpée.

8. Procédé selon l'une quelconque des revendications 1 à 7, **caractérisé en ce qu'**à chaque fois au moins une languette de fixation (26) est placée sur les connecteurs métalliques (22).

9. Procédé selon l'une quelconque des revendications 1 à 8, **caractérisé en ce que** les barrettes de liaison (24) comportent latéralement un chanfrein (28) .
